# FASCICULE DE BREVET EUROPEEN

(11) **EP 4 176 463 B1**
(45) Date de publication et mention de la délivrance du brevet: **12.06.2024**
(21) Numéro de dépôt: 21720818.0
(22) Date de dépôt: 30.03.2021
(51) Int. Cl.: H01L 21/322, H01L 21/762, H01L 21/324

(54) **SUBSTRAT SUPPORT POUR STRUCTURE SOI ET PROCEDE DE FABRICATION ASSOCIE**
TRÄGERSUBSTRAT FÜR SOI-STRUKTUR UND ZUGEHÖRIGES HERSTELLUNGSVERFAHREN
CARRIER SUBSTRATE FOR SOI STRUCTURE AND ASSOCIATED MANUFACTURING METHOD

(30) Priorité: 03.07.2020 FR 2007096
(43) Date de publication de la demande: 10.05.2023
(73) Titulaire: SOITEC, 38190 Bernin (FR)
(72) Inventeur: BERTRAND, Isabelle, 38190 BERNIN (FR); ALLIBERT, Frédéric, 38000 GRENOBLE (FR); BOUVEYRON, Romain, 38100 GRENOBLE (FR); SCHWARZENBACH, Walter, 38330 SAINT NAZAIRE LES EYMES (FR)
(74) Mandataire: IP Trust
(86) Numéro de dépôt international: PCT/FR2021/050560
(87) Numéro de publication internationale: WO 2022/003262

(56) Documents cités:
- EP-A2- 1 713 121
- DE-A1-102020 107 236

## Description

### DOMAINE DE L'INVENTION

La présente invention vise le domaine des semi-conducteurs et de la microélectronique. Elle concerne un substrat support en silicium pour une structure Silicium sur Isolant (SOI), en particulier pour une structure SOI complètement désertée (FD-SOI pour « fully depleted silicon on insulator »), adaptée pour les applications logiques et radiofréquences. L'invention concerne également un procédé de fabrication d'un tel substrat support.

### ARRIERE PLAN TECHNOLOGIQUE DE L'INVENTION

L'intérêt de la technologie FD-SOI est déjà largement documenté pour les applications logiques à faible puissance et radiofréquences.

Pour adresser les spécifications sévères de ces applications, la structure FD-SOI doit répondre à plusieurs critères.

D'une part, la couche utile très fine (typiquement de l'ordre de 20nm) en silicium doit présenter une excellente uniformité d'épaisseur, ainsi qu'une haute qualité cristalline. Pour cela, elle doit pouvoir subir des traitements à hautes températures de longue durée, notamment lors de sa fabrication ; lesdits traitements sont requis pour lisser la surface libre de la couche utile et guérir des défauts cristallins présents dans cette dernière. Cela implique que le substrat support de la structure SOI soit résistant au mode de défaillance de type lignes de glissement (« slip lines » selon la terminologie anglo-saxonne), et en particulier, qu'il présente une densité de micro-défauts (BMD pour « bulk micro-defect ») suffisante et homogène sur toute son étendue. Ces micro-défauts sont habituellement présents en quantité suffisante dans les substrats à haute teneur en oxygène interstitiel (dits « high Oi »), correspondant typiquement à une concentration en Oi supérieure à 1E18/cm3 (norme ASTM'79) : ces substrats support « high Oi » sont particulièrement robustes aux défauts de type lignes de glissement.

D'autre part, la structure SOI doit être compatible avec des seuils d'inspection très bas, afin d'autoriser la détection de défauts de taille inférieure à 50 nm sur et/ou dans la couche utile. Il est connu qu'un substrat support à haute teneur en oxygène interstitiel (Oi) comporte des défauts appelés « particules d'origine cristalline » (COP) qui limitent l'inspectabilité de la couche utile de la structure SOI ; en effet, les défauts COP situés dans une zone superficielle du substrat support, même s'ils demeurent sous la couche d'oxyde enterré de la structure SOI, sont détectés lors de l'inspection de la couche utile à des seuils de détection très poussés, du fait de la pénétration du signal d'inspection qui va légèrement sonder sous la couche d'oxyde enterré. Un substrat support à haute teneur en Oi n'est donc pas compatible, en l'état, avec de telles applications.

Enfin, pour satisfaire aux exigences radiofréquences, le substrat support de la structure SOI doit présenter une résistivité haute (supérieure à 500ohm.cm, à 1000ohm.cm, voire supérieure à 5000ohm.cm) et stable. Pour obtenir ces propriétés, il est habituel d'utiliser des substrats supports très résistifs et à faible teneur en Oi (dits « low Oi », correspondant typiquement à une concentration en Oi inférieure à 8E17 Oi/cm³), car ceux à haute teneur en Oi montrent une instabilité de résistivité en profondeur, notamment du fait des traitements thermiques de lissage requis pour la couche utile. Malheureusement, les substrats supports à faible teneur en Oi sont extrêmement sensibles aux longs traitements à hautes températures et présentent consécutivement une forte densité de lignes de glissement dommageables pour la structure SOI.

EP 1 713 121 A2 divulgue un substrat support.

### OBJET DE L'INVENTION

La présente invention propose une solution remédiant à tout ou partie des inconvénients précités. Elle concerne en particulier un substrat support compatible avec les traitements thermiques imposés à une structure SOI et avec les spécifications sévères des applications logiques et radiofréquences. L'invention concerne également un procédé de fabrication d'un tel substrat support.

### BREVE DESCRIPTION DE L'INVENTION

La présente invention concerne un substrat support en silicium monocristallin, présentant une face avant et une face arrière et comprenant :
- une région superficielle allant de la face avant jusqu'à une profondeur comprise entre 800nm et 2 microns, présentant moins de dix particules d'origine cristalline (COP) détectées par une inspection de surface basée sur la microscopie par réflexion en champ sombre,
- une région supérieure s'étendant de la face avant jusqu'à une profondeur comprise entre quelques microns et 40 microns, présentant une teneur en oxygène interstitiel (Oi) inférieure ou égale à 7,5E17 Oi/cm³ et une résistivité supérieure à 500 ohm.cm, et
- une région inférieure s'étendant entre la région supérieure et la face arrière, présentant une concentration en micro-défauts (BMD) supérieure ou égale à 1E8/cm³.

Selon des caractéristiques avantageuses de l'invention, prises seules ou selon toute combinaison réalisable :
- la résistivité de la région supérieure est supérieure ou égale à 750 ohm.cm, voire supérieure ou égale à 1000ohm.cm ;
- la région supérieure s'étend jusqu'à une profondeur comprise entre 10 microns et 30 microns ;
- la concentration de micro-défauts (BMD) dans la région inférieure est comprise entre 1E8/cm³ et 3E10/cm³, préférentiellement entre 1E9/cm³ et 2E10/cm³.

L'invention concerne également une structure SOI comprenant une couche utile disposée sur une couche diélectrique, elle-même disposée sur un substrat support tel que ci-dessus.

La couche utile peut présenter une épaisseur inférieure à 50nm, préférentiellement comprise entre 4nm et 25nm ; et la couche diélectrique peut présenter une épaisseur comprise entre 10nm et 150nm.

L'invention concerne en outre un composant électronique pour application logique faible puissance et radiofréquence comprenant au moins un transistor disposé sur et/ou dans la couche utile d'une structure SOI telle que ci-dessus.

Enfin l'invention concerne un procédé de fabrication d'un substrat support tel que précité. Le procédé de fabrication comprend les étapes suivantes :
a) la fourniture d'un substrat initial en silicium monocristallin, présentant une teneur en oxygène interstitiel comprise entre 12E17 Oi/cm3 et 16E17 Oi/cm3, et une résistivité supérieure à 500 ohm.cm, le substrat initial étant destiné à former le substrat support après avoir subi les étapes b) et c) subséquentes,
b) l'application d'un premier traitement thermique à une température comprise entre 1150°C et 1250°C, sous atmosphère neutre ou réductrice, pendant une durée supérieure ou égale à 30 min, pour former la région superficielle et la région supérieure du substrat support,
c) l'application d'un deuxième traitement thermique comprenant une première séquence de recuit à une température comprise entre 600°C et 900°C, et une deuxième séquence de recuit à une température comprise entre 950°C et 1100°C, pour former la région inférieure du substrat support.

Avantageusement, la première séquence du deuxième traitement thermique comprend deux plateaux de température, un premier plateau entre 650°C et 750°C, et un second plateau autour de 800°C.

### BREVE DESCRIPTION DES DESSINS

D'autres caractéristiques et avantages de l'invention ressortiront de la description détaillée qui va suivre en référence aux figures annexées sur lesquelles :
- La figure 1 présente un substrat support conforme à l'invention ;
- La figure 2 présente une structure SOI comprenant une substrat support conforme à l'invention ;
- Les figures 3a à 3c présentent des étapes du procédé de fabrication du substrat support, conforme à l'invention.
- La figure 4 présente deux cartographies issues d'une inspection de surface par microscopie par réflexion en champ sombre de la surface d'un substrat initial (a) non traité par le procédé de fabrication conforme à l'invention, et d'un substrat intermédiaire (b) après le premier traitement thermique du procédé de fabrication conforme à l'invention ;
- La figure 5 présente une tranche du substrat support conforme à l'invention, après révélation chimique des micro-défauts de type BMD ;
- La figure 6 présente une courbe de la résistivité en fonction de la profondeur, pour un substrat support conforme à l'invention.

Les mêmes références sur les figures pourront être utilisées pour des éléments de même nature.

Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y.

### DESCRIPTION DETAILLEE DE L'INVENTION

L'invention concerne un substrat support 10 en silicium monocristallin, présentant une face avant 10a et une face arrière 10b, sensiblement parallèles à un plan principal (x,y). Il se présente avantageusement sous la forme d'une plaquette de forme circulaire, de diamètre compris entre 200mm et 450mm. Son épaisseur totale, selon l'axe z normal au plan principal (x,y), peut varier entre quelques centaines de microns et 1000 microns.

Le substrat support 10 comprend une région superficielle 1 allant de la face avant 10a jusqu'à une profondeur de l'ordre d'un micron, typiquement comprise entre 800nm et 2 microns. Cette région superficielle 1 présente la particularité d'une très faible densité de particules d'origine cristalline (COP). Un moyen simple de détecter ces COP est d'utiliser un instrument d'inspection de surface basé sur la microscopie par réflexion en champ sombre, habituellement mis en oeuvre pour la mesure de défectivité de surface. On peut utiliser par exemple un équipement de type KLA-Tencor Surfscan SP2 (marque déposée), connu dans le domaine de la microélectronique. En mode d'incidence oblique (canal oblique étroit ou « narrow ») et avec un seuil de détection de 44nm, moins de dix COP sont détectés au niveau de la face avant 10a d'un substrat support 10 conforme à l'invention.

Le substrat support 10 comprend une région supérieure 2 s'étendant de la face avant 10a jusqu'à une profondeur comprise entre quelques microns et 40 microns, préférentiellement, jusqu'à une profondeur comprise entre 10 microns et 30 microns. La région supérieure 2 inclut donc la région superficielle 1. La région supérieure 2 présente une teneur en oxygène interstitiel (Oi) inférieure ou égale à 7,5E17 Oi/cm³ (équivalent à une teneur inférieure ou égale à 15 ppma (selon la norme ASTM'79). Elle présente en outre une résistivité supérieure à 500 ohm.cm, correspondant à une faible concentration en dopant de type P (bore). Avantageusement, sa résistivité est même supérieure ou égale à 750 ohm.cm, voire supérieure ou égale à 1000ohm.cm. Le niveau de résistivité est défini en fonction de l'application visée et des composants électroniques qui seront ultérieurement élaborés au-dessus du substrat support 10. Les gammes de résistivité de la région supérieure 2 sont particulièrement adaptées aux composants radiofréquences visant les applications dans le spectre 30 - 300GHz, impliquant des longueurs d'onde millimétriques (« mmWave ») et dont on parle notamment pour supporter le réseau 5G des prochaines générations de téléphones mobiles.

Le substrat support 10 comprend enfin une région inférieure 3 s'étendant entre la région supérieure 2 et la face arrière 10b, dont l'épaisseur est de l'ordre de quelques centaines de microns. Cette région inférieure 3 présente une concentration en micro-défauts (BMD) supérieure ou égale à 1E8/cm³, ce qui lui confère une grande robustesse mécanique aux traitements thermiques à hautes températures. La concentration de micro-défauts (BMD) dans la région inférieure 3 est préférentiellement comprise entre 1E8/cm³ et 3E10/cm³, et encore préférentiellement entre 1E9/cm³ et 2E10/cm³.

La région inférieure 3 présente une résistivité typiquement supérieure ou égale à 250 ohm.cm et potentiellement fluctuante, qui n'a pas de réelle influence sur les futurs composants radiofréquences car les champs électromagnétiques générés par lesdits composants n'atteignent pas ou de façon très marginale la région inférieure 3. Seule la résistivité de la région supérieure 2 doit présenter une valeur stable et suffisamment élevée.

Pour permettre l'élaboration de composants, une couche utile, sur ou dans laquelle se situeront lesdits composants, doit être reportée sur le substrat support 10.

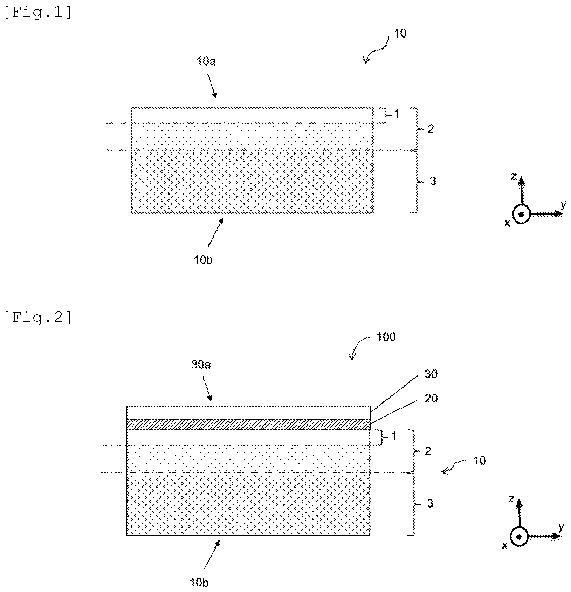

L'invention concerne donc également une structure Silicium sur Isolant (SOI) 100 comprenant une couche utile 30 disposée sur une couche diélectrique 20, elle-même disposée sur un substrat support 10 précité (figure 2).

La couche utile 30 est en silicium monocristallin de haute qualité et présente une épaisseur inférieure à 50nm, préférentiellement comprise entre 4nm et 25nm. Cette gamme d'épaisseur est particulièrement adaptée aux composants électroniques basés sur des technologies et architectures de type FD-SOI. La couche diélectrique 20, par exemple en oxyde de silicium, présente quant à elle une épaisseur comprise entre 10nm et 150nm.

La présence de la région superficielle 1 du substrat support 10, présentant une très faible densité de particules d'origine cristalline (COP) confère au substrat SOI 100 une excellente inspectabilité, à des seuils de détection très bas (<50nm). La qualité de la couche utile 30 peut donc être contrôlée finement et manière fiable, sans gêne et/ou fausse détection liées à la présence de COP en surface du substrat support 10.

L'invention concerne également un composant électronique pour application logique faible puissance et radiofréquences. Un tel composant comprend en particulier, au moins un transistor disposé sur et/ou dans la couche utile 30 de la structure SOI 100. Les caractéristiques de la région supérieure 2 du substrat support 10, à savoir la résistivité et la faible concentration en Oi, confèrent à cette région de très bonnes performances d'isolation : en effet, au-delà de son niveau élevé, la résistivité est également stable dans cette région 2 car elle ne subit pas de fluctuations liées à une trop forte concentration en Oi, apte à générer des donneurs thermiques d'oxygène et de petites BMD compensant le dopage de type P initial. La région supérieure 2 ne subit donc pas de chute ou de forte fluctuation de résistivité au cours des traitements thermiques à hautes températures (>1100°C) appliqués à la structure SOI 100. De plus, la forte densité de micro-défauts (BMD) dans la région inférieure 3 du substrat support 10 confèrent à ce dernier une excellente résistance mécanique et une insensibilité aux défauts de type lignes de glissement, lors desdits traitements thermiques.

L'invention concerne en outre un procédé de fabrication d'un substrat support 10 tel que précédemment décrit.

Le procédé de fabrication comprend une étape a) de fourniture d'un substrat initial 10' en silicium monocristallin, présentant une teneur en oxygène interstitiel comprise entre 12E17 Oi/cm³ et 16E17 Oi/cm³ (équivalent à une teneur comprise entre 24 et 32 ppma ASTM'79). Notons qu'un substrat avec une teneur comprise entre 24 et 28 ppma (ASTM'79) est habituellement considéré comme étant à moyenne teneur en Oi (« mid Oi ») ; un substrat avec une teneur comprise entre 27 et 32 ppma (ASTM'79) est habituellement considéré comme étant à haute teneur en Oi (« high Oi »).

Le substrat initial 10' présente une résistivité supérieure à 500 ohm.cm, soit une concentration en dopants de type P (Bore) inférieure ou égale à 2,6E13/cm³. Il est destiné à former le substrat support 10 après avoir subi les étapes b) et c) subséquentes du procédé. Ainsi, la résistivité du substrat initial 10' est choisie à la valeur requise pour la région supérieure 2 du substrat support 10, en fonction de l'application visée. Avantageusement, la résistivité du substrat initial 10' est supérieure ou égale à 750 ohm.cm, voire supérieure ou égale à 1000ohm.cm.

Au cours de l'étape b) suivante du procédé, un premier traitement thermique à une température comprise entre 1150°C et 1250°C, sous atmosphère neutre ou réductrice est appliqué au substrat initial 10'. La durée de ce traitement est supérieure ou égale à 30 min, par exemple, comprise entre 5h et 10h.

Ce premier traitement thermique a pour rôle de dissoudre des particules d'origine cristalline (COP) dans une région superficielle du substrat initial 10', sur une profondeur comprise entre 800nm et 2 microns. Cela mène à la formation de la région superficielle 1 du futur substrat support 10.

La dissolution des COP peut par exemple être réalisée par recuit rapide (RTA pour « rapid thermal anneal »), à une température autour de 1250°C, pendant 10s, sous atmosphère neutre (Argon) ou réductrice (Argon et Hydrogène), avec des rampes de montée et de descente rapide (50°C/min). Alternativement, un recuit en four classique, par exemple à 1200°C, pendant 30min ou 1h, toujours sous atmosphère neutre ou réductrice, permet également d'opérer la dissolution des COP dans la région superficielle 1.

Le premier traitement thermique a également pour rôle d'exo-diffuser de l'oxygène interstitiel (Oi) et d'appauvrir le substrat initial 10' en Oi dans une région allant de sa face avant 10a à une profondeur plus ou moins importante, en fonction de la durée du traitement thermique. Typiquement, pour une température de traitement de 1200°C et une durée de 10h, le substrat se trouve appauvri en Oi sur une profondeur de l'ordre de 20 microns. Cela mène à la formation de la région supérieure 2 du futur substrat support 10.

Le premier traitement thermique peut ainsi consister soit en un unique recuit, qui va jouer les deux rôles énoncés ci-dessus, soit en une séquence de recuits dans les mêmes équipements ou dans des équipements différents, pour réaliser la dissolution des COP et l'exo-diffusion de l'oxygène interstitiel séquentiellement.

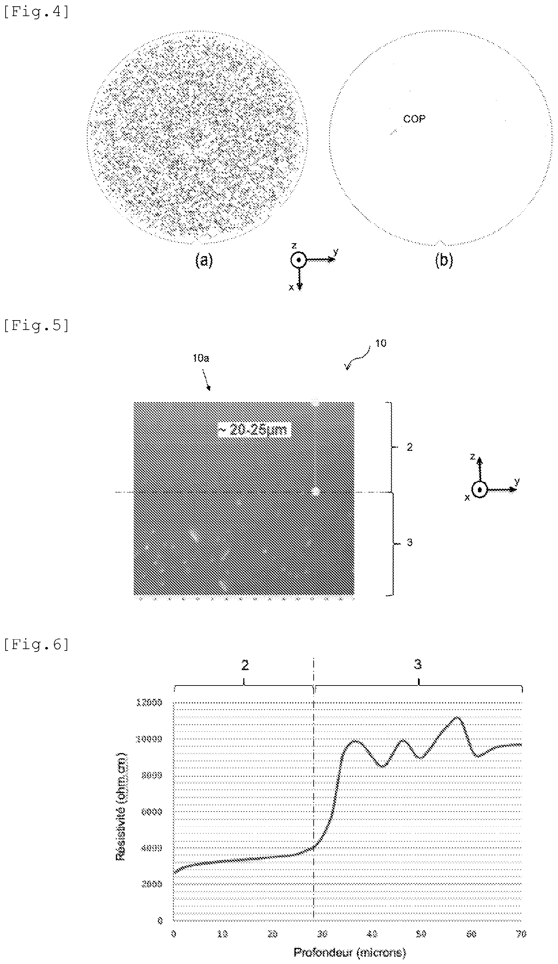

A l'issue du premier traitement thermique, on obtient un substrat intermédiaire 10" qui comprend une région superficielle 1 allant de la face avant 10a jusqu'à une profondeur comprise entre 800nm et 2 microns. Cette région superficielle 1 présente une très faible densité de particules d'origine cristalline (COP) comme cela est illustré sur la figure 4(b), en comparaison avec la figure 4(a) qui correspond au substrat initial 10', avant tout traitement. Les cartographies de la figure 4 ont été réalisées à partir d'un équipement de type KLA-Tencor SP2, en mode d'incidence oblique et avec un seuil de détection de 44nm, sur des plaquettes de 300mm de diamètre : on détecte plus de 1000 COP au niveau de la face avant 10a d'un substrat initial 10' fourni à l'étape a) du procédé ; après le premier traitement thermique de l'étape b), on détecte moins de dix COP, voire moins de cinq COP, au niveau de la face avant 10a du substrat intermédiaire 10" (un COP seulement dans l'exemple de la figure 4(b)).

Après un retrait de matière d'environ 1 micron au niveau de la face avant 10a du substrat intermédiaire 10", on remarque que le nombre de COP détectés reste très bas, toujours inférieur ou égal à 10. Cela permet d'évaluer l'épaisseur de la région superficielle 1 à faible densité de COP.

Le substrat intermédiaire 10" comprend également une région supérieure 2 s'étendant de la face avant 10a jusqu'à une profondeur comprise entre quelques microns et 40 microns, préférentiellement, jusqu'à une profondeur comprise entre 10 microns et 30 microns. La région supérieure 2 présente une teneur en oxygène interstitiel (Oi) inférieure ou égale à 7,5E17 Oi/cm³, appauvri par rapport à la teneur en Oi du substrat initial 10', du fait du premier traitement thermique. La résistivité de la région supérieure 2 est celle du substrat initial 10', soit supérieure à 500 ohm.cm. Cette région supérieure 2 peut être assimilée à du silicium à faible teneur en Oi (« low Oi »), ce qui lui confère une excellente stabilité en termes de résistivité, même lorsque le substrat sera soumis à de très hautes températures.

Le procédé de fabrication comprend ensuite une étape c) au cours de laquelle un deuxième traitement thermique est appliqué au substrat intermédiaire 10". Ce traitement comprend une première séquence de recuit à une température comprise entre 600°C et 900°C, et une deuxième séquence de recuit à une température comprise entre 950°C et 1100°C.

La première séquence de recuit comprend deux plateaux de températures. Un premier plateau entre 650°C et 750°C d'une durée comprise entre 30min et 10h, sous atmosphère neutre ou avec faible flux d'oxygène (typiquement autour de 0,075 litre par minute standard (slm) d'O2 et autour de 0,015 slm d'O2, respectivement dans un four pour plaquettes 300mm et un four pour plaquettes 200mm) . Ce premier plateau a pour rôle de favoriser la nucléation de défauts dits « noyaux », de petite taille (typiquement inférieure à 10nm, voire à 5nm), en particulier dans la région inférieure (sous la région supérieure 2) du substrat intermédiaire 10" qui comprend une forte concentration de Oi. Ces noyaux sont des petits précipités de SiOx, amorcés soit de manière hétérogène, c'est-à-dire sur des défauts préexistants dans le matériau (lacunes), soit de manière homogène, c'est-à-dire par la migration d'atomes d'oxygène et de création de liaisons SiO2 et SiOx. Ils ne se forment pas, ou de manière pas significative dans la région supérieure 2 appauvrie en Oi. De plus, même si une petite quantité de noyaux se forme dans la région supérieure 2, ils ne pourront pas grossir lors de la deuxième séquence du deuxième traitement thermique (décrit plus loin) du fait de la faible quantité d'Oi, et ils seront donc dissous.

Un second plateau autour de 800°C, d'une durée comprise entre 30min et 10 h, sous atmosphère neutre ou avec faible flux d'oxygène : cela permet d'induire une seconde phase de nucléation en formant d'autres noyaux dans la région inférieure du substrat intermédiaire 10", entre les premiers noyaux, et ainsi d'augmenter leur densité. Notons qu'il est possible d'utiliser une atmosphère oxydante (humide ou sèche), préférentiellement après que la moitié, voire les trois-quarts de la durée du second plateau se soit(ent) écoulée(és) .

La deuxième séquence du deuxième traitement thermique, d'une durée comprise entre 5h et 20h, va ensuite provoquer la diffusion de l'oxygène interstitiel Oi et sa précipitation sur les nombreux noyaux présents dans la région inférieure du substrat 10", ce qui va les faire grossir et les rendre stables dans le matériau. Les micro-défauts ainsi créés sont connus sous l'appellation BMD pour « bulk micro defects ».

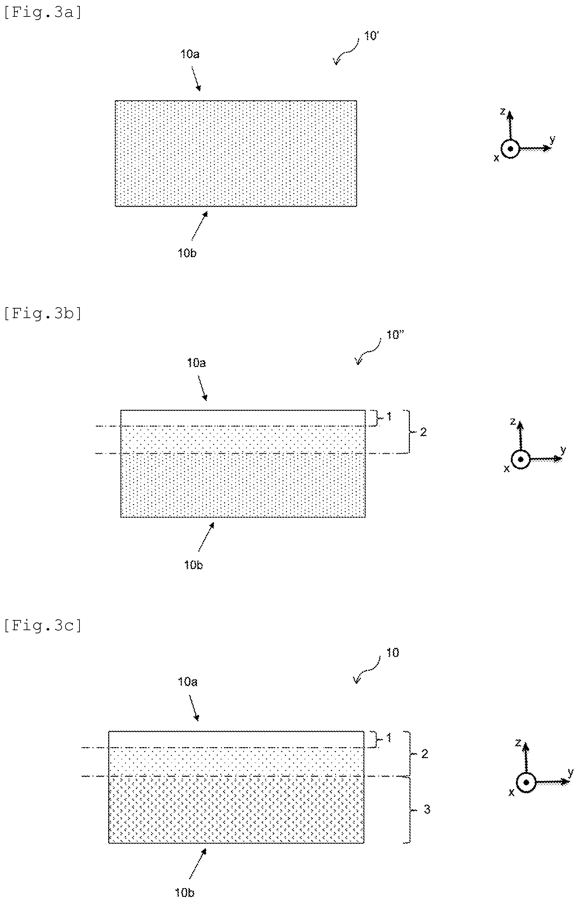

La région inférieure 3 du substrat support 10 riche en micro-défauts BMD est ainsi formée (figure 3c). En particulier, on atteint une concentration en BMD dans la région inférieure 3 comprise entre 1E8/cm³ et 3E10/cm³, et préférentiellement entre 1E9/cm³ et 2E10/cm³. La figure 5 correspond à une image au microscope optique de la tranche d'un substrat support 10, après une gravure chimique de révélation des micro-défauts BMD : on observe une zone sans défaut sur une épaisseur de l'ordre de 20-25 microns dans la région supérieure 2. Au contraire, la région inférieure 3 comprend une forte densité de défauts BMD, de l'ordre de quelques 1E9/cm³, typiquement entre 2E9/cm³ et 5E9/cm³ dans cet exemple.

La figure 6 illustre une courbe de résistivité en fonction de la profondeur pour un substrat support 10 conforme à l'invention. Le substrat initial 10' présentait une résistivité de l'ordre de 3500ohm.cm et une haute teneur en Oi. Après le procédé de fabrication de l'invention, le substrat support 10 présente une résistivité supérieure ou égale à 3000ohm.cm et stable sur les trente premiers microns (région supérieure 2). La région inférieure 3 présente une résistivité très haute et fluctuante, du fait de la densité élevée d'oxygène interstitiel. Notons que cette résistivité peut encore évoluer au cours des procédés de fabrication de la structure SOI et des composants microélectroniques, alors que la région supérieure 2 conservera son niveau de résistivité et sa faible teneur en COP (région superficielle 1).

Un tel substrat support 10 peut être employé dans un procédé de fabrication d'une structure SOI 100 telle qu'illustrée sur la figure 2. L'élaboration d'une structure SOI 100 est préférentiellement basée sur le procédé de transfert de couches minces connu sous l'appellation procédé Smart Cut^{™}.

Un substrat donneur en silicium monocristallin est implanté par sa face avant, de manière à définir un plan fragile enterré sensiblement parallèle à la face avant et délimitant, avec cette dernière, la couche mince 30,20 à reporter. L'implantation est habituellement faite avec des espèces légères telles que des ions d'hydrogène, d'hélium ou une combinaison de ces deux espèces. Le plan fragile est ainsi nommé car il comprend des nano-fissures sous forme lenticulaire générées par les espèces légères implantées.

Selon une option préférentielle, la couche mince 30,20 à reporter comprend, de la face avant du substrat donneur jusqu'au plan fragile enterré, une couche diélectrique 20 et une couche en silicium 30 lesquelles formeront respectivement la couche diélectrique enterrée 20 et la couche utile 30 en silicium de la structure SOI 100. On comprendra donc que l'énergie d'implantation des espèces légères est choisie et ajustée de manière à former le plan fragile enterré (plus ou moins localisé au niveau du pic d'implantation) à la profondeur correspondant à l'épaisseur souhaitée de couche utile 30, en tenant compte d'étapes de finition (évoquées ci-après) qui consomment une partie de matière de ladite couche 30.

Le substrat donneur et le substrat support 10 sont ensuite assemblés, par collage direct entre les faces avant desdits substrats, pour former un ensemble collé. Des nettoyages et/ou activations de surface, bien connus dans le domaine du collage par adhésion moléculaire, pourront être appliqués aux substrats préalablement à l'assemblage, pour obtenir une excellente qualité de collage. Un assemblage en atmosphère contrôlée est également possible.

La séparation au niveau du plan fragile enterré s'effectue préférentiellement par application d'un traitement thermique à température moyenne, typiquement entre 350°C et 500°C, du fait de la croissance de microfissures par coalescence et mise sous pression des espèces gazeuses. Alternativement ou conjointement, la séparation peut être provoquée par l'application d'une contrainte mécanique à l'ensemble collé.

A l'issue de cette séparation, on obtient une structure SOI intermédiaire d'une part, et le reste du substrat donneur, d'autre part. Des séquences de finition comprenant des nettoyages, des traitements de surface (gravure, polissage, etc.) et/ou des traitements thermiques sont habituellement appliquées à la structure SOI intermédiaire, et visent à retirer une partie de matière de la couche utile 30 reportée. Cela permet de restaurer un bon état de surface (défectivité et rugosité) et une bonne qualité cristalline à la couche utile 30 en silicium. A la suite de quoi, la structure SOI 100 est disponible.

Les traitements thermiques de finition précités sont habituellement opérés à des températures comprises entre 900°C et 1250°C : la robustesse de la région inférieure 3 du substrat support 10 aux défauts de type lignes de glissement (« slip lines ») et autres déformations plastiques, est un atout significatif lors de ces traitements et permet de conserver une très bonne intégrité de la structure SOI 100.

Bien que l'élaboration de la structure SOI 100 ait été décrite ici en référence au procédé Smart Cut, une telle structure peut également être réalisée à partir d'autres procédés de transfert de couches minces connus de l'état de la technique.

Des composants électroniques RF (par exemple, « mmWave ») peuvent ensuite être réalisés sur ou dans la couche utile 30, basés notamment sur au moins un transistor CMOS (« complementary métal oxide semiconductor »). A nouveau, les caractéristiques du substrat support 10 de la structure SOI 100 favorisent :
- l'inspectabilité de la structure 100 au cours des différentes étapes d'élaboration des composants, grâce à la présence de la région superficielle 1 à très faible densité de COP ;
- éventuellement, l'élaboration de tout ou partie de composants dans la région superficielle 1, pour une intégration hybride SOI / Si massif ;
- la tenue mécanique de la structure 100 lors des multiples séquences de traitements thermiques à hautes températures mises en oeuvre dans les technologies CMOS de fabrication des composants, du fait de la forte densité de micro-défauts BMD dans la région inférieure 3 du substrat support 10, ladite région 3 correspondant à la majorité de l'épaisseur dudit substrat 10. En ciblant avantageusement une densité de BMD entre 1E9/cm³ et 2E10/cm³, les lignes de glissement et/ou autres déformations plastiques dans le substrat support 10, qui provoquent des problèmes d'alignement aux différents niveaux de lithographie (« overlay »), sont évitées ou largement minimisées ;
- les performances RF des composants, du fait de la résistivité élevée et stable de la région supérieure 2 du substrat support 10 : la faible teneur en Oi de cette région assure une grande stabilité de sa résistivité malgré les multiples traitements thermiques ; son épaisseur est adaptée à la pénétration des champs électromagnétiques générés par les composants RF et évite que ceux-ci n'atteignent la région inférieure 3, dont la résistivité est mal contrôlée et potentiellement à un niveau trop bas pour l'application visée.

Les composants électroniques peuvent notamment consister en des commutateurs RF (« switch »), des amplificateurs de puissance (« power amplifier PA »), des amplificateurs faible bruit (« low noise amplifier LNA »), des émetteurs/récepteurs, etc.

Bien sûr, l'invention n'est pas limitée aux modes de réalisation décrits et on peut y apporter des variantes de réalisation sans sortir du cadre de l'invention tel que défini par les revendications.

En particulier, la couche utile 30 utilisée pour l'élaboration des composants a été décrite dans le cadre d'une structure SOI, donc constituée de silicium ; mais il est tout à fait envisageable que la couche utile 30 comprenne d'autres types de matériaux, semi-conducteurs ou pas. De même, la couche diélectrique 20 peut comprendre différents types de matériaux isolants électriques.

## Revendications

1. Substrat support (10) en silicium monocristallin, présentant une face avant (10a) et une face arrière (10b) et comprenant :
- une région superficielle (1) allant de la face avant (10a) jusqu'à une profondeur comprise entre 800nm et 2 microns, présentant moins de dix particules d'origine cristalline (COP) détectées par une inspection de surface basée sur la microscopie par réflexion en champ sombre,
- une région supérieure (2) s'étendant de la face avant (10a) jusqu'à une profondeur comprise entre quelques microns et 40 microns, présentant une teneur en oxygène interstitiel (Oi) inférieure ou égale à 7,5E17 Oi/cm³ et une résistivité supérieure à 500 ohm.cm, et
- une région inférieure (3) s'étendant entre la région supérieure (2) et la face arrière (10b), présentant une concentration en micro-défauts (BMD) supérieure ou égale à 1E8/cm³.

2. Substrat support (10) selon la revendication précédente, dans lequel la résistivité de la région supérieure (2) est supérieure ou égale à 750 ohm.cm, voire supérieure ou égale à 1000ohm.cm.

3. Substrat support (10) selon l'une des revendications précédentes, dans lequel la région supérieure (2) s'étend jusqu'à une profondeur comprise entre 10 microns et 30 microns.

4. Substrat support (10) selon l'une des revendications précédentes, dans lequel la concentration de micro-défauts (BMD) dans la région inférieure (3) est comprise entre 1E8/cm³ et 3E10/cm³, préférentiellement entre 1E9/cm³ et 2E10/cm³.

5. Structure SOI (100) comprenant une couche utile (30) disposée sur une couche diélectrique (20), elle-même disposée sur un substrat support (10) selon l'une des revendications précédentes.

6. Structure SOI (100) selon la revendication précédente, dans laquelle la couche utile (30) présente une épaisseur inférieure à 50nm, préférentiellement comprise entre 4nm et 25nm.

7. Structure SOI (100) selon l'une des deux revendications précédentes, dans laquelle la couche diélectrique (20) présente une épaisseur comprise entre 10nm et 150nm.

8. Composant électronique pour application logique faible puissance et radiofréquence comprenant au moins un transistor disposé sur et/ou dans la couche utile (30) d'une structure SOI (100) selon l'une des trois revendications précédentes.

9. Procédé de fabrication d'un substrat support (10) selon l'une des revendications 1 à 4, le procédé de fabrication comprenant les étapes suivantes :
a) la fourniture d'un substrat initial (10') en silicium monocristallin, présentant une teneur en oxygène interstitiel comprise entre 12E17 Oi/cm³ et 16E17 Oi/cm³, et une résistivité supérieure à 500 ohm.cm, le substrat initial (10') étant destiné à former le substrat support (10) après avoir subi les étapes b) et c) subséquentes,
b) l'application d'un premier traitement thermique à une température comprise entre 1150°C et 1250°C, sous atmosphère neutre ou réductrice, pendant une durée supérieure ou égale à 30 min, pour former la région superficielle (1) et la région supérieure (2),
c) l'application d'un deuxième traitement thermique comprenant une première séquence de recuit à une température comprise entre 600°C et 900°C, et une deuxième séquence de recuit à une température comprise entre 950°C et 1100°C, pour former la région inférieure (3) du substrat support (10).

10. Procédé de fabrication selon la revendication précédente, dans lequel la première séquence du deuxième traitement thermique comprend deux plateaux de température, un premier plateau entre 650°C et 750°C, et un second plateau autour de 800°C.

## Patentansprüche

1. Monokristallines Siliziumträgersubstrat (10), aufweisend eine Vorderseite (10a) und eine Rückseite (10b) und umfassend:
- einen Oberflächenbereich (1), der sich von der Vorderseite (10a) bis zu einer Tiefe zwischen 800 nm und 2 Mikrometer erstreckt, aufweisend weniger als zehn Partikel kristallinen Ursprungs (COP), die durch eine Oberflächenprüfung basierend auf der Dunkelfeld-Reflexionsmikroskopie festgestellt werden,
- einen oberen Bereich (2), der sich von der Vorderseite (10a) bis zu einer Tiefe zwischen einigen Mikrometern und 40 Mikrometern erstreckt, aufweisend einen Gehalt an Zwischengittersauerstoff (Oi) von weniger als oder gleich 7,5E17 Oi/cm³ und einen spezifischen Widerstand von mehr als 500 Ohm.cm und
- einen unteren Bereich (3), der sich zwischen dem oberen Bereich (2) und der Rückseite (10b) erstreckt, aufweisend eine Konzentration von Mikrodefekten (BMD) von größer als oder gleich 1E8/cm³.

2. Trägersubstrat (10) nach dem vorstehenden Anspruch, wobei der spezifische Widerstand des oberen Bereichs (2) größer als oder gleich 750 Ohm.cm oder sogar größer als oder gleich 1000 Ohm.cm beträgt.

3. Trägersubstrat (10) nach einem der vorstehenden Ansprüche, wobei der obere Bereich (2) sich bis zu einer Tiefe zwischen 10 Mikrometern und 30 Mikrometern erstreckt.

4. Trägersubstrat (10) nach einem der vorstehenden Ansprüche, wobei die Konzentration von Mikrodefekten
(BMD) in dem unteren Bereich (3) zwischen 1E8/cm³ und 3E10/cm³, vorzugsweise zwischen 1E9/cm³ und 2E10/cm³, beträgt.

5. SOI-Struktur (100), umfassend eine Nutzschicht (30), die auf einer dielektrischen Schicht (20) angeordnet ist, die wiederum auf einem Trägersubstrat (10) nach einem der vorstehenden Ansprüche angeordnet ist.

6. SOI-Struktur (100) nach dem vorstehenden Anspruch, wobei die Nutzschicht (30) eine Dicke von weniger als 50 nm, vorzugsweise zwischen 4 nm und 25 nm, aufweist.

7. SOI-Struktur (100) nach einem der zwei vorstehenden Ansprüche, wobei die dielektrische Schicht (20) eine Dicke zwischen 10 nm und 150 nm aufweist.

8. Elektronisches Bauelement für eine Logikanwendung mit niedriger Leistung und Hochfrequenz, umfassend mindestens einen Transistor, der auf und/oder in der Nutzschicht (30) einer SOI-Struktur (100) nach einem der drei vorstehenden Ansprüche angeordnet ist.

9. Verfahren zum Herstellen eines Trägersubstrats (10) nach einem der Ansprüche 1 bis 4, das Herstellungsverfahren umfassend die folgenden Schritte:
a) Bereitstellen eines Ausgangssubstrats (10') aus monokristallinem Silizium, aufweisend einen Gehalt an Zwischengittersauerstoff zwischen 12E17 Oi/cm³ und 16E17 Oi/cm³ und einem spezifischen Widerstand von mehr als 500 Ohm.cm, wobei das Ausgangssubstrat (10') dafür bestimmt ist, das Trägersubstrat (10) auszubilden, nachdem es die nachfolgenden Schritte b) und c) durchlaufen hat,
b) Anwenden einer ersten Wärmebehandlung bei einer Temperatur zwischen 1150 °C und 1250 °C unter neutraler oder reduzierender Atmosphäre während einer Dauer von mehr als oder gleich 30 min, um den Oberflächenbereich (1) und den oberen Bereich (2) auszubilden,
c) Anwenden einer zweiten Wärmebehandlung, umfassend eine erste Glühsequenz bei einer Temperatur zwischen 600 °C und 900 °C und eine zweite Glühsequenz bei einer Temperatur zwischen 950 °C und 1100 °C, um den unteren Bereich (3) des Trägersubstrats (10) auszubilden.

10. Herstellungsverfahren nach dem vorstehenden Anspruch, wobei die erste Sequenz der zweiten Wärmebehandlung zwei Temperaturplateaus, ein erstes Plateau zwischen 650 °C und 750 °C und ein zweites Plateau um 800 °C, umfasst.

## Claims

1. Support substrate (10) made of monocrystalline silicon, having a front face (10a) and a rear face (10b) and comprising:
- a surface region (1) extending from the front face (10a) to a depth of between 800 nm and 2 microns, having fewer than ten crystal originated particles (COP) detected by a surface inspection based on dark-field reflection microscopy,
- an upper region (2) extending from the front face (10a) to a depth of between a few microns and 40 microns, which has an interstitial oxygen (Oi) content of less than or equal to 7.5E17 Oi/cm³ and a resistivity greater than 500 ohm-cm, and
- a lower region (3) extending between the upper region (2) and the rear face (10b), which has a micro-defect (BMD) concentration of greater than or equal to 1E8/cm³.

2. Support substrate (10) according to the preceding claim, wherein the resistivity of the upper region (2) is greater than or equal to 750 ohm-cm, or even greater than or equal to 1000 ohm-cm.

3. Support substrate (10) according to one of the preceding claims, wherein the upper region (2) extends to a depth of between 10 microns and 30 microns.

4. Support substrate (10) according to one of the preceding claims, wherein the concentration of micro-defects
(BMD) in the lower region (3) is between 1E8/cm³ and 3E10/cm³, preferably between 1E9/cm³ and 2E10/cm³.

5. SOI structure (100) comprising a useful layer (30) arranged on a dielectric layer (20), which is itself arranged on a support substrate (10), according to one of the preceding claims.

6. SOI structure (100) according to the preceding claim, wherein the useful layer (30) has a thickness of less than 50 nm, preferably between 4 nm and 25 nm.

7. SOI structure (100) according to one of the two preceding claims, wherein the dielectric layer (20) has a thickness of between 10 nm et 150 nm.

8. Electronic component for low-power logic and radiofrequency applications, comprising at least one transistor arranged on and/or in the useful layer (30) of a SOI structure (100) according to one of the three preceding claims.

9. Method for producing a support substrate (10) according to one of claims 1 to 4, the production method comprising the following steps:
a) providing an initial substrate (10') made of monocrystalline silicon, which has an interstitial oxygen content of between 12E17 Oi/cm³ and 16E17 Oi/cm³, and a resistivity greater than 500 ohm-cm, the initial substrate (10') being intended to form the support substrate (10) after undergoing the subsequent steps b) and c),
b) applying a first heat treatment at a temperature of between 1150°C and 1250°C, in a neutral or reducing atmosphere, for a time greater than or equal to 30 min, to form the surface region (1) and the upper region (2),
c) applying a second heat treatment comprising a first annealing sequence at a temperature of between 600°C and 900°C, and a second annealing sequence at a temperature of between 950°C and 1100°C, to form the lower region (3) of the support substrate (10).

10. Production method according to the preceding claim, wherein the first sequence of the second heat treatment comprises two temperature plateaus, a first plateau between 650°C and 750°C, and a second plateau around 800°C.
